# EUROPEAN PATENT APPLICATION

(11) **EP 1 956 655 A2**
(43) Date of publication of application: **13.08.2008**
(21) Application number: 08001463.2
(22) Date of filing: 26.01.2008
(51) Int. Cl.: H01L 27/12, H01L 21/77

(54) **Display device and method of manufacturing the same**

(30) Priority: 09.02.2007 KR 20070013867
(71) Applicant: Samsung Electronics Co., Ltd., Yeongtong-gu Suwon-city, Gyeonggi-do 442-742 (KR)
(72) Inventor: Goh, Joon-chul, Seoul (KR); Yoon, Young-soo, Suwon-si, Gyeonggi-do (KR)
(74) Representative: Dr. Weitzel & Partner

(57) **Abstract**

A display device includes a first conductive layer including a driving source electrode and a driving drain electrode, a second conductive layer insulated from the first conductive layer, and including a driving gate electrode, a switching gate electrode, and a gate line, and a third conductive layer insulated from the first and second conductive layers, and including a switching source electrode, a switching drain electrode, a data line, and a common power line.

## Description

### BACKGROUND OF THE INVENTION

### Field of the Invention

Apparatuses and methods consistent with the present invention relate to a display device and a manufacturing method thereof, and more particularly, to a display device that suppresses an occurrence of a defect and improves electric characteristics, and a manufacturing method thereof.

### Discussion of Related Art

There are various types of display devices.

Among the various types of display devices, a liquid crystal display (LCD) device and an organic light emitting diode (OLED) display are light-weighted and small-sized and have performance that improves with developing semiconductor technology.

The LCD device and the OLED display device typically use a display panel having a thin film transistor (TFT) having a gate electrode, a source electrode, and a drain electrode. The display panel displays an image using a plurality of pixels. The pixel is a minimum unit that may be displayed.

In the OLED, more than two TFTs are formed in one pixel, and lines including a common power line, a gate line, and a data line are respectively connected to the TFTs.

The TFT is formed by overlapping a plurality of conductive layers, a semiconductor layer, and an insulating layer. Therefore, the TFT has a curved and a stepped structure. The insulating layer is thinly formed on the curved and a stepped structure. The thin insulating layer is easily damaged by an operation voltage so that short-circuit between the conductive layers may occur.

In addition, a hillock may occur depending on the type of a metal used for the conductive layer. The hillock in the conductive layer damages a thin portion of the insulating layer. Therefore, the hillock in the conductive layer may cause a short-circuit between the conductive layers.

In order to solve such a problem, a thin conductive layer disposed under the insulating layer may be formed by using a metal having appropriate thermal stability.

The thermally stable metal tends to have high resistivity, and therefore, electric characteristics of the conductive layer may be deteriorated to cause a serious voltage drop.

Accordingly, a constant voltage may not be applied to all pixels of the display device.

### SUMMARY OF THE INVENTION

According to an embodiment of the present invention a display device includes a first conductive layer including a driving source electrode and a driving drain electrode, a second conductive layer insulated from the first conductive layer, and including a driving gate electrode, a switching gate electrode, and a gate line, and a third conductive layer insulated from the first and second conductive layers, and including a switching source electrode, a switching drain electrode, a data line, and a common power line. According to an embodiment of the invention, the first conductive layer is made of a first metal having high thermal stability compared to the third conductive layer, and the third conductive layer is made of a third metal having low resistivity compared to the first conductive layer.

According to an embodiment of the invention, the second conductive layer is made of a second metal containing at least one of molybdenum (Mo), chromium (Cr), titanium (Ti), tantalium (Ta), copper (Cu), aluminum (A1), and silver (Ag), wherein the first metal is one of molybdenum (Mo), chromium (Cr), titanium (Ti), and tantalium (Ta), and the third metal is one of copper (Cu), aluminum (Al), and silver (Ag).

According to an embodiment of the invention, the switching gate electrode is branched from the gate line, the switching source electrode is branched from the data line, the switching drain electrode is electrically connected to the driving gate electrode, and the driving source electrode is electrically connected to the common power line.

According to an embodiment of the invention, the display device further includes a first storage electrode extended from the driving source electrode, and a second storage electrode branched from the driving gate electrode and overlapping the first storage electrode, wherein the first storage electrode and the second storage electrode form a capacitor.

According to an embodiment of the invention, the display device further includes a first connection member and a second connection member formed on a layer that is different from the first, second, and third conductive layers, wherein the first connection member electrically connects the switching drain electrode and the driving gate electrode, and the second connection member electrically connects the common power line and the driving source electrode.

According to an embodiment of the invention, the first conductive layer further includes an auxiliary common power line extended from the driving source electrode, and the auxiliary common power line overlaps the common power line.

According to an embodiment of the invention, the display device further includes an organic light emitting element electrically connected to the driving drain electrode.

According to an embodiment of the invention, the organic light emitting element includes a pixel electrode formed on the third conductive layer and insulated therefrom and electrically connected to the driving drain electrode, an organic layer formed on the first pixel electrode, and a common electrode formed on the organic layer.

According to an embodiment of the invention, the pixel electrode is made of at least one of indium tin oxide (ITO) and indium zinc oxide (IZO).

According to an embodiment of the invention, the driving gate electrode, the driving source electrode, and the driving drain electrode form a driving thin film transistor, and the switching gate electrode, the switching source electrode, and the switching drain electrode from a switching thin film transistor.

According to an embodiment of the invention, the driving thin film transistor further includes a driving semiconductor layer made of polysilicon, and the switching thin film transistor further includes a switching semiconductor layer made of amorphous silicon.

According to an embodiment of the invention, the driving semiconductor layer is disposed below and overlapping the driving source electrode, the driving drain electrode, and the driving gate electrode, and the driving thin film transistor further includes driving ohmic contact layers respectively interposed between the driving source electrode and the driving semiconductor layer and between the driving drain electrode and the driving semiconductor layer.

According to an embodiment of the invention, the driving semiconductor layers are interposed between the gate electrode and the driving source electrode and between the gate electrode and the driving drain electrode, and the driving thin film transistor further includes driving ohmic contact layers interposed between the driving source electrode and the driving semiconductor and between the driving drain electrode and the driving semiconductor layer.

According to an embodiment of the present invention a display device manufacturing method includes preparing a substrate member, forming a first conductive layer including a driving source electrode and a driving drain electrode on the substrate member, forming a second conductive layer including a driving gate electrode, a switching gate electrode, and a gate line on the substrate member having the first conductive layer formed thereon, and forming a third conductive layer including a switching source electrode, a switching drain electrode, a data line, and a common power line on the substrate member having the first conductive layer and the second conductive layer formed thereon.

According to an embodiment of the invention, the first conductive layer is made of a first metal having high thermal stability compared to the third conductive layer, and the third conductive layer is made of a second metal having low resistivity compared to the first conductive layer.

According to an embodiment of the invention, the first, second, third conductive layers are respectively insulated from each other, the driving source electrode and the common electrode line are electrically connected to each other, and the switching drain electrode is electrically connected to the driving gate electrode.

According to an embodiment of the invention, the driving device manufacturing method further includes forming a pixel electrode electrically connected to the driving drain electrode, forming an organic layer on the pixel electrode; and forming a common electrode on the organic layer.

According to an embodiment of the invention, further includes forming a driving thin film transistor including the driving gate electrode, the driving source electrode, and the driving drain electrode, the driving thin film transistor further includes a driving semiconductor layer made of polysilicon, forming a switching thin film transistor including the switching gate electrode, the switching source electrode, and the switching drain electrode, and the switching thin film transistor further includes a switching semiconductor made of amorphous silicon.

### BRIEF DESCRIPTION OF THE DRAWINGS

The prevent invention will become apparent and more readily appreciated from the following description of exemplary embodiments, taken in conjunction with the accompanying drawings, in which:

FIG. 1 is a layout view of a display device according to an exemplary embodiment of the present invention;

FIG. 2 is a cross-sectional view of the display device, taken along lines II-II and II'-II' of FIG. 1;

FIG. 3 to FIG. 9 show layout views and cross-sectional views of a manufacturing process of the display device of FIG. 1; and

FIG. 10 is a partial cross-sectional view of a display device according to an exemplary embodiment of the present invention.

### DETAILED DESCRIPTION OF EXEMPLARY EMBODIMENTS

Reference will now be made in detail to embodiments of the present invention, examples of which are illustrated in the accompanying drawings. As those skilled in the art would realize, described embodiments may be modified in various different ways, all without departing from the spirit or scope of the present invention.

The accompanying drawings illustrate an organic light emitting diode (OLED) display as a display device.

In addition, the accompanying drawings illustrate an active matrix (AM)-type OLED display having a 2Tr-1Cap structure wherein one pixel includes two thin film transistors (TFTs) and one capacitor. The structure of the AM-type OLED is not limited thereto.

The pixel is a minimum unit for display using the display device.

In the display device, one pixel may include more than three TFTs and more than two capacitors, and additional wiring may be further provided.

Like reference numerals refer to like elements throughout. Exemplary embodiments are described below so as to explain the present invention with reference to the figures.

In the drawings, the thickness of layers, films, panels, regions, etc., may be exaggerated for clarity. It will be understood that when an element such as a layer, film, region, or substrate is referred to as being "on" another element, it can be directly on the other element or intervening elements may also be present. When an element is referred to as being "directly on" another element, there are no intervening elements present.

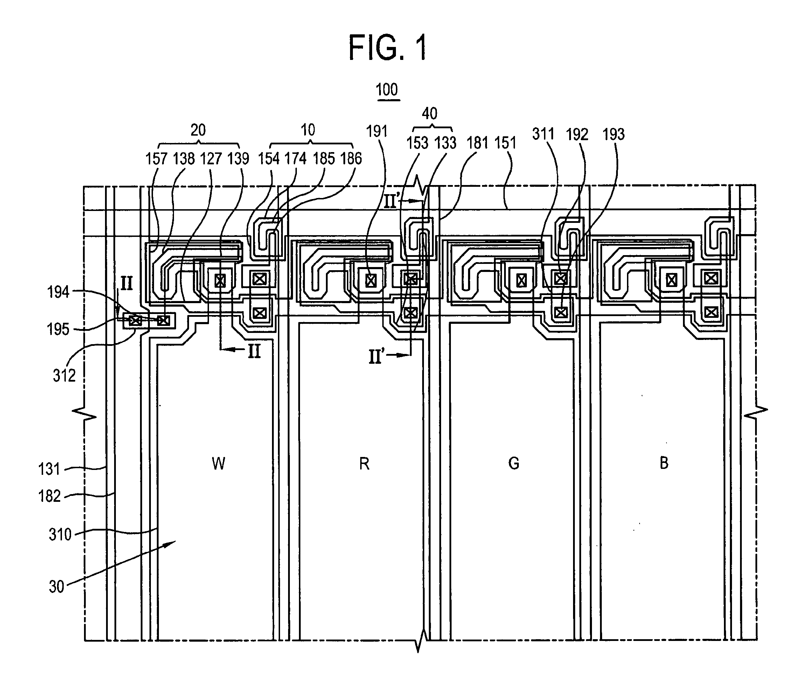

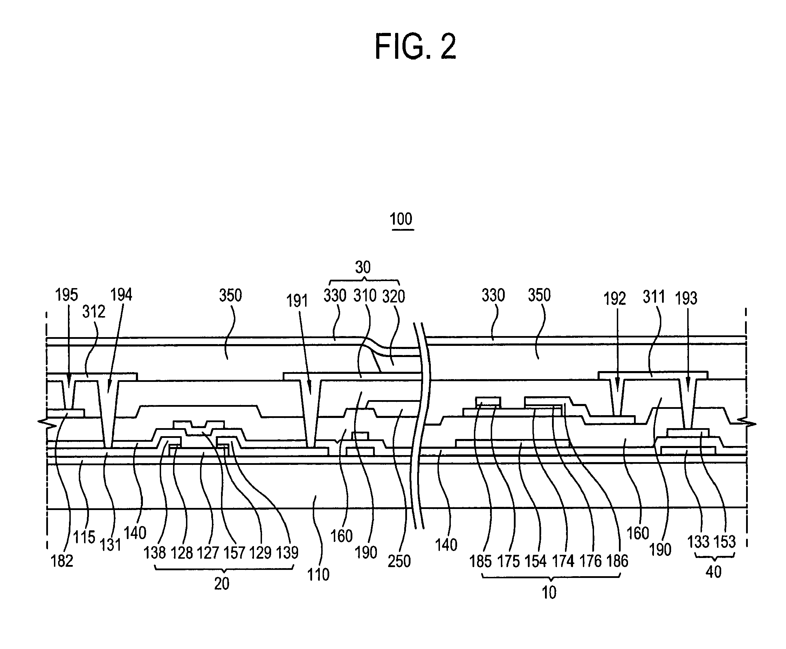

FIG. 1 is a partial layout view of a display device according to an exemplary embodiment of the present invention. FIG. 2 is a cross-sectional view of the display device of FIG. 1, taken along lines II-II and II'-II' of FIG. 1.

As shown in FIG. 1, each pixel of a display device 100 includes a switching TFT 10, a driving TFT 20, a capacitor 40, and an organic light emitting element 30. The display device 100 further includes a gate line 151 extending in a first direction, a data line 181 crossing the gate line 151, and a common power line 182. The data line 181 and the common power ling 182 are insulated from the gate line 151. In addition, the display device 100 further includes an auxiliary common power line 131. Constituent elements of the display device according to an exemplary embodiment of the present invention are not limited thereto. That is, the auxiliary common power line 131 can be omitted.

The organic light emitting diode 30 includes a pixel electrode 310, an organic layer (320 of FIG. 2) formed on the pixel electrode 310, and a common electrode (330 of FIG. 2) formed on the organic layer 320. The pixel electrode 310 serves as a hole injection electrode (e.g., positive electrode) and the common electrode serves as an electron injection electrode (e.g., negative electrode). Holes and electrons are respectively injected into the organic layer 320 from the pixel electrode 310 and the common electrode 320. The injected holes and electrons form excitons. When the energy state of excitons changes from an excited state to a ground state, light is emitted.

The switching TFT 10 includes a switching gate electrode 154, a switching source electrode 185, and a switching drain electrode 186. The driving TFT 20 includes a driving gate electrode 157, a driving source electrode 138, and a driving drain electrode 139.

The capacitor 40 includes a first storage electrode 133 and a second storage electrode 153. A first insulation layer (140 FIG. 2) is interposed between the first storage electrode 133 and the second storage electrode 153.

The driving source electrode 138, the driving drain electrode 139, the first storage electrode 133, and the auxiliary common power line 131 are formed in a first conductive layer. The driving gate electrode 157, the switching gate electrode 154, the second storage electrode 153, and the gate line 151 are formed in a second conductive layer. The switching source electrode 185, the switching drain electrode 186, the data line 181, and the second common power line 182 are formed in a third conductive layer. In this case, the second conductive layers 151, 153, 154, and 157 are formed on the first conductive layers 131, 133, 138, and 139, and the third conductive layers 181, 182, 185, and 186 are formed on the second conductive layers 151, 153, 154, and 157.

The auxiliary common power line 131 is arranged along the common power line 182 and overlaps the common power line 182. The auxiliary common power line 131 and the common power line 182 are electrically connected to each other. The first storage electrode 133 and the auxiliary common power line 131 are extended from the driving source electrode 138.

The switching TFT 10 is used as a switching element for selecting a light emitting pixel. The switching gate electrode 154 is branched from the gate line 151. The switching source electrode 185 is branched from the data line 181. The switching drain electrode 186 is independently disposed and electrically connected with the second storage electrode 153. The second storage electrode 153 is extended from the driving gate electrode 157.

The switching TFT 10 further includes a switching semiconductor layer 174. The switching semiconductor layer 174 is interposed between the switching gate electrode 154 and the switching source electrode 185, and between the switching gate electrode 154 and the switching drain electrode 186. The switching semiconductor layer 174 overlaps the switching gate electrode 154. At least a portion of the switching source electrode 185 and at least a portion of the switching drain electrode 186 overlap the switching semiconductor layer 174.

The switching TFT 10 further includes switching ohmic contact layers 175 and 176 respectively interposed between the switching semiconductor layer 174 and the switching source electrode 185, and between the switching semiconductor layer 174 and the switching drain electrode 186. The switching ohmic contact layer 175 contacts the switching semiconductor layer 174 and the switching source electrode 185. The switching ohmic contact layer 176 contacts the switching semiconductor layer 174 and the switching drain electrode 186.

The driving thin film transistor 20 applies a driving power to the pixel electrode 310 for emitting light from the organic layer 320 of a selected organic light emitting diode 30.

The driving gate electrode 157 of the driving TFT 20 is extended and forms the second storage electrode 153. The driving gate electrode 157 is electrically connected with the switching drain electrode 186. The driving source electrode 138 is electrically connected to the common power line 182. The driving drain electrode 139 is electrically connected to the pixel electrode 310 of the organic light emitting diode 30. Herein, the pixel electrode 310 is electrically connected to the driving drain electrode 139 through a first contact hole 191.

The driving TFT 20 includes a driving semiconductor layer 127. The driving semiconductor layer 127 is arranged below, and overlaps, the driving gate electrode 157, the driving source electrode 138, and the driving drain electrode 139.

The driving TFT 20 further includes driving ohmic contact layers 128 and 129 respectively interposed between the driving source electrode 138 and the driving semiconductor layer 127 and between the driving drain electrode 139 and the driving semiconductor layer 127. The driving ohmic contact layer 128 contacts the driving semiconductor layer 127 and the driving source electrode 138. The driving ohmic contact layer 129 contacts the driving semiconductor layer 127 and/or the driving drain electrode 139.

The display device 100 further includes a first connecting member 311 and a second connecting member 312 which are formed on the same layer as the pixel electrode 310.

The first connecting member 311 electrically connects the switching drain electrode 186 and the driving gate electrode 157, and more particularly, electrically connects the switching drain electrode 186 and the second storage electrode 153 extended from the driving gate electrode 157. The first connecting member 311 is electrically connected to the switching drain electrode 186 and the second storage electrode 153 through the second contact hole 192 and the third contact hole 193.

The second connecting member 312 electrically connects the driving source electrode 138 and the common power line 182 which are formed on different layers. The second connecting member 312 is electrically connected to the driving source electrode 138 and the common power line 182 through a fourth contact hole 194 and a fifth contact hole 195. Therefore, the auxiliary common power line 131 is electrically connected to the common power line 182.

The first conductive layers 131, 133, 138, and 139 are made of a metal including at least one of molybdenum (Mo), chromium (Cr), titanium (Ti), and tantalum (Ta). The first conductive layers 131, 133, 138, and 139 are preferably formed in a single-layered structure by using a metal having excellent thermal stability, such as molybdenum (Mo) and chromium (Cr).

The second conductive layers 151, 153, 154, and 157 are made of a metal including at least one of molybdenum (Mo), chromium (Cr), titanium (Ti), tantalum (Ta), aluminum (Al), copper (Cu), and silver (Ag). The second conductive layers 151, 153, 154, and 157 are preferably formed in a single-layered structure or a multi-layered structure by using various metals and alloys thereof as needed.

The third conductive layers 181, 182, 185, and 186 are made of a metal having a low resistivity, including at least one of aluminum (A1), copper (Cu), and silver (Ag). The third conductive layers 181, 182, 185, and 186 are preferably formed in a signal-layered structure made of aluminum (Al) or a multi-layered structure made of a low resistive metal, such as molybdenum (Mo)/aluminum (A1)/molybdenum (Mo).

The first conductive layers 131, 133, 138, and 139 have superior thermal stability compared to the third conductive layers 181, 182, 185, and 186, and the third conductive layers 181, 182, 185, and 186 have relatively low resistivity.

With the above-described configuration, the occurrence of a defect such as a short-circuit can be suppressed and electric characteristics of the display device 100 can be improved by reducing the overall resistivity.

The first conductive layers 131, 133, 138, and 139 including the driving source electrode 138 and the driving drain electrode 139 of the driving TFT 20 are made of a metal having relatively superior thermal stability. Therefore, hillock formation in the driving source electrode 138 and the driving drain electrode 139 can be suppressed. Accordingly, the driving source electrode 138 and the driving drain electrode 139 can be substantially prevented from being short-circuited with another conductive layer.

The first conductive layers 131, 133, 138, and 139 are made to be relatively thinner than other conductive layers by using a metal having excellent thermal stability and hillocks are substantially prevented from being formed. The first conductive layers 131, 133, 138, and 139 can be formed as a single-layered structure, thereby reducing the thickness thereof, and a step due to the source electrode 138 and the driving drain electrode 139 can be reduced. The first insulating layer 140 covering the driving source electrode 138 and the driving drain electrode 139 can be substantially prevented from being thinned. A short-circuit between the driving source electrode 138 and the driving drain electrode 139 and another conductive layer such as the driving gate electrode 157 can be substantially prevented.

The auxiliary common power line 131 included in the first conductive layers 131, 133, 138, 139 is made of a metal having excellent thermal stability and relatively high resistivity.

The common power line 182 arranged overlapping the auxiliary common power line 131 and electrically connected with the auxiliary common power line 131 and the driving source electrode 138 is included in the third conductive layers 181, 182, 185, and 186 which are made of a metal having relatively low resistivity. A voltage drop occurring when a current flows only through the auxiliary common power line 131 can be suppressed since the current can flow through the common power line 182. The current mainly flows through the common power line 182 and then is transmitted to the driving source electrode 138, improving electric characteristics of the display device 100, wherein a constant voltage can be applied to an organic light emitting diode 30 of each pixel.

Since the common power lines 131 and 182 are formed in different two layers, an operation error can be substantially prevented even though one of the common power lines 131 and 182 is disconnected.

The overall resistance of the display device 100 is reduced, and widths of the common power line 182 and the auxiliary common power line 131 can be reduced, enabling the display device 100 to have an improved aperture ratio.

A structure of the display device 100 according to an exemplary embodiment of the present invention will be described in further detail with reference to FIG. 2.

A substrate member 110 may be an insulating substrate such as glass, crystal, ceramic, or plastic, or a metallic substrate made of stainless steel. When the substrate member 110 is made of a material having flexibility, a utilization range of the display device 100 can be increased so that availability of the display device 100 can be improved.

A buffer layer 115 is formed on the substrate member 110. The buffer layer 115 substantially prevents an impurity element from penetrating thereto and planarizes the surface. The buffer layer 115 may be omitted depending on the type of the substrate member 110 and the type of the semiconductor layer 127.

A driving semiconductor layer 127 is formed on the buffer layer 115. The driving semiconductor layer 127 is made of polysilicon. On the buffer layer 115 and the driving semiconductor layer 127, a first conductive layer including an auxiliary common power line 131, a first storage electrode 133, a driving source electrode 138, and a driving drain electrode 139 is formed. The first storage electrode 133 and the common power line 131 are extended from the auxiliary driving source electrode 138, and the driving drain electrode 139 is independently formed. The first conductive layers 131, 133, 138, and 139 are made of a metal having superior thermal stability compared to other conductive layers, particularly, the third conductive layers 181, 182, 185, and 186, and have a relatively thin thickness. Portions of the driving source electrode 138 and portions of the driving drain electrode 139 overlap the driving semiconductor layer 127.

Driving ohmic contact layers 128 and 129 are interposed between the driving semiconductor layer 127 and the driving source electrode 138 and between the driving semiconductor layer 127 and the driving drain electrode 139. The driving ohmic contact layers 128 and 129 are made of n+ polysilicon in which an n-type impurity is highly doped. The driving ohmic contact layers 128 and 129 reduce a contact resistance between the driving semiconductor layer 127 and the driving drain electrode 139 and between the driving semiconductor layer 127 and the driving drain electrode 139.

A first insulating layer 140 is formed on the first conductive layers 131, 133, 138, and 139. On the first insulating layer 140, a second conductive layer including a gate line 151, a driving gate electrode 157, a switching gate electrode 154, and a second storage electrode 153 is formed. The switching gate electrode 154 is branched from the gate line 151 and the driving gate electrode 157 is independently formed. The second storage electrode 153 is extended from the driving gate electrode 157 and overlaps the first storage electrode 133.

On the second conductive layers 151, 153, 154, and 157, a second insulating layer 160 is formed. A switching semiconductor layer 174 is formed on the second insulating layer. The switching semiconductor layer 174 is made of an amorphous silicon layer.

On the second insulating layer 160 and the switching semiconductor layer 174, a third conductive layer including a common power line 182, a data line 181, a switching source electrode 185, and a switching drain electrode 186 is formed. The switching source electrode 185 is branched from the data line 181 and the switching drain electrode 186 is independently formed. Portions of the switching source electrode 185 and portions of the switching drain electrode 186 overlap the switching semiconductor layer 174. The common power line 182 overlaps the auxiliary common power line 131.

Switching ohmic contact layer 175 and 176 are formed between the switching semiconductor layer 174 and the switching source electrode 185 and between switching semiconductor layer 174 and the switching drain electrode 186. The switching ohmic contact layers 175 and 176 are made of n+ amorphous silicon in which an n-type impurity is highly doped. The switching ohmic contact layers 175 and 176 reduce a contact resistance between the driving semiconductor layer 174 and the driving drain electrode 186 and between the driving semiconductor layer 174 and the driving drain electrode 186.

A passivation layer 190 is formed on the third conductive layers 181, 182, 185, and 186. The passivation layer 190 preferably has a characteristic of planarization. The passivation layer 190 includes a plurality of contact holes including a first contact hole 191, a second contact hole 192, a third contact hole 193, a fourth contact hole 194, and a fifth contact hole 195.

The first contact hole 191 is formed together with the passivation layer 190, the first insulating layer 140 and the second insulating layer 160, and partially exposes the driving drain electrode 139. The second contact hole 192 partially exposes the switching drain electrode 186. The third contact hole 193 is formed together with the passivation layer 190 and the second insulating layer 160, and partially exposes the second storage electrode 153. The fourth contact hole 194 is formed together with the passivation layer 190, the first insulating layer 140, and the second insulating layer 160, and partially exposes the first common power line 131. The fifth contact hole 195 partially exposes the second common power line 182.

On the passivation layer 190, a pixel electrode 310, a first connecting member 311, and a second connecting member 312 are formed. The pixel electrode 310 is electrically connected to the driving drain electrode 139 through the first contact hole 191. The first connecting member 311 connects the switching drain electrode 186 and the second storage electrode 153 through the second contact hole 192 and the third contact hole 193. The second connecting member 312 connects the driving source electrode 138 and the common power line 182 through the fourth contact hole 194 and the fifth contact hole 195. Accordingly, the common power line 182 and the auxiliary common power line 131 are electrically connected to each other.

The pixel electrode 310, the first connecting member 311, and the second connecting member 312 are formed of a transparent conductive layer made of at least one of indium tin oxide (ITO) and indium zinc oxide (IZO).

A pixel definition layer 350 is formed on the pixel electrode 310, the first connecting member 311, and the second connecting member 312. The pixel definition layer 350 includes an opening exposing the pixel electrode 310.

In the opening of the pixel definition layer 350, an organic layer 320 is formed on the pixel electrode 310. A common electrode 300 covers the pixel definition layer 350 and the organic layer 320. The pixel electrode 310, the organic layer 320, and the common electrode 330 form an organic light emitting diode 30. Since the passivation layer 190 is formed flat, the pixel electrode 310 and the organic layer 320 formed on the passivation layer 190 are also flat. As described, when the organic layer 320 is formed flat and thus has a substantially uniform thickness, the organic light emitting diode 30 can have substantially uniform luminance. The organic layer 320 is made of a low molecular organic material or a polymer material.

Further, the organic layer 320 may be formed as multiple layers including a hole-injection layer (HIL), a hole-transporting layer (HTL), an emission layer, an electron-transporting layer (ETL), and an electron-injection layer (EIL). The HIL is disposed on the pixel electrode 310 which is a positive electrode, and the HTL, the emission layer, the ETL, and the EIL are sequentially stacked on the HIL.

The HIL and the HTL may be provided as an amine derivative with strong fluorescence, for example, a triphenyldiamine derivative, a styryl amine derivative, and an amine derivative having an aromatic condensed ring.

The ETL may be provided as a quinoline derivative, particularly, aluminum tris (8-hydroxyquinoline) (Alq3). The ETL may also be provided as a phenyl anthracene derivative or a tetrarylethene derivative.

The EIL may be provided as barium (Ba) or calcium (Ca).

The emission layer emits light. According to an exemplary embodiment of the present invention, the display device 200 further includes a color filter 250 formed overlapping the organic layer 320 and disposed under the passivation layer 190. Therefore, light emitted from the organic layer 320 has color. The color filter 250 has three primary colors of red, green, and blue. However, it not limited thereto, and the color filter 250 may have other colors than red, green, and blue.

A portion of the organic layer 320 does not overlap the color filter 250. As described, a pixel where the color filter 250 is not formed represents white.

Four pixels, emitting while light, red light, blue light, and green light, respectively, form one group. Pixels included in one group are electrically connected to the same power line 182 and the same auxiliary common power line 131, respectively.

The structure of the pixel is not limited thereto. The emission layer 320 may directly emit light to the three primary colors and the white color.

When the organic layer 320 is made of polymer material, the organic layer 320 can be formed by using an ink jet method. In the case where an ink jet is used, the HIL can be made of a hole injection material such as poly (3,4-ethylene dioxythiphene) (PEDOT) or polystyrene sulfonate (PSS). The emission layer may be made of a polymer, such as a polyfluorene derivative, a (poly)paraphenylenevinylene derivative, a polyphenylene derivative, a polyvinylcarbazole derivative, a polythiophene derivative, and aforementioned polymer doped with a perylene pigment, a rodermine pigment, rubrene, perylene, 9,10-diphenylanthracene, tetraphenylbutadiene, Nile red, coumarin 6, or quinacridone.

According to an exemplary embodiment, the pixel electrode 310 is the positive electrode and the common electrode 330 is the negative electrode, but they are not limited thereto.

The pixel electrode 310 may be the negative electrode and the common electrode 330 may be the positive electrode. In this case, the organic layer 320 is formed by sequentially stacking the EIL, the ETL, the emission layer, the HTL, and the HIL on the pixel electrode 310.

The switching TFT 10 is an amorphous silicon thin film transistor including the switching semiconductor layer 174 made of amorphous silicon. The driving TFT 20 is a polysilicon thin film transistor including the semiconductor layer 127 made of polysilicon.

The amorphous silicon thin film transistor has a small leakage current, but becomes unstable in quality when it is used for a long period of time. On the other hand, the polysilicon thin film transistor is stable in quality but has a relatively large leakage current.

When the polysilicon thin film transistor is used as the driving TFT 20, the amount of leakage current in the turn-off state does not cause the organic light emitting diode 30 to be turned on, and therefore, the leakage current does not cause a problem. However, when the polysilicon thin film transistor is used as the switching TFT 10, a defect such as cross talk occurs due to the leakage current.

The driving TFT 20 is provide as polysilicon thin film transistor in order to maintain the stability of the display device, and the switching TFT 10 is provided as amorphous silicon thin film transistor to thereby substantially prevent the defect such as the cross talk.

Although it is not shown in FIG. 2, the display device 100 may further include an encapsulation member to protect the common electrode 330 and prevent moisture and air from being permeating into the organic layer 320. The encapsulation member may include a encapsulation resin and a encapsulation can.

With the above-described configuration, occurrence of a defect such as short-circuit can be suppressed and at the same time, electric characteristics of the display device 100 can be improved by lowering overall resistivity.

According to an exemplary embodiment of the present invention, the second conductive layers 151, 153, 154, and 157 are formed on the first conductive layer 131, 133, 138, and 139, and the third conductive layers 181, 182, 185, and 186 are formed on the second conductive layer 151, 153, 154, and 157. A structure is not limited thereto. The arrangements of the first conductive layers 131, 133, 138, and 139, the second conductive layers 151, 153, 154, and 157, and the third conductive layers 181, 182, 185, and 186 may vary.

The auxiliary common electrode 131 can be omitted.

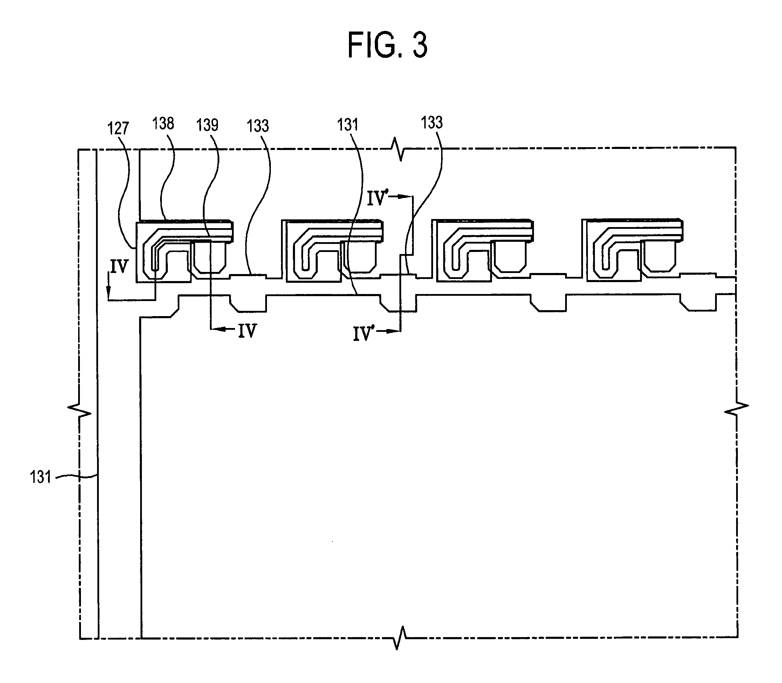

A manufacturing method of the display device 100 according to an exemplary embodiment of the present invention will be described in further detail with reference to FIG. 3 to FIG. 9.

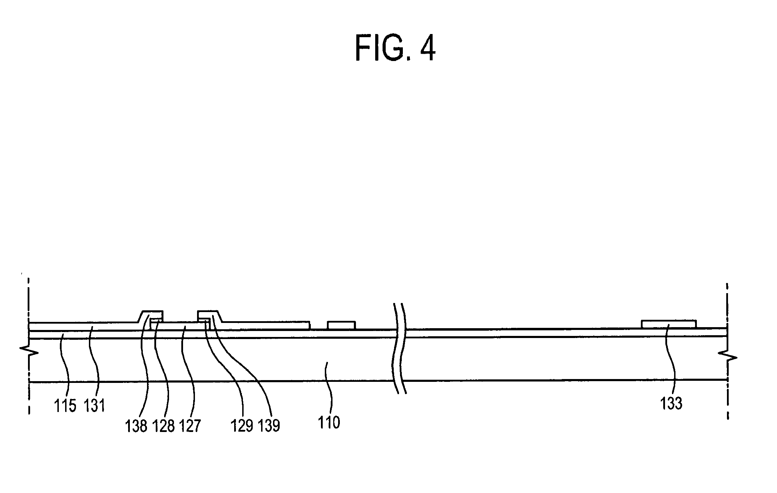

As shown in FIG. 3 and FIG. 4, the buffer layer 115 is formed on the substrate member 110. The buffer layer 115 may be made of silicon oxide. The driving semiconductor layer 127 is formed on the buffer layer 115. The driving semiconductor layer 127 is formed as a polysilicon layer. The driving semiconductor layer 127 is formed by depositing an amorphous silicon layer and then polycrystalizing the amorphous silicon layer. The amorphous silicon layer can be crystallized by using a solid phase crystallization (SPC) method, an excimer laser crystallization (ELC) method, a metal induced crystallization (MIC) method, a metal induced lateral crystallization (MILC) method, or a sequential lateral solidification (SLS) method.

On the driving semiconductor layer 127, the driving ohmic contact layers 128 and 129 are formed. The driving ohmic contact layer 128 and 129 are formed as a polysilicon layer highly doped with an n-type impurity.

A single-layer made of a metal having excellent thermal stability, such as molybdenum (Mo), chromium (Cr), titanium (Ti), and tantalum (Ta) is deposited by using a sputtering method is patterned so as to form the first conductive layers 131, 133, 138, and 139. The first conductive layers include the first common power line 131, the first storage electrode 133, the driving source electrode 138, and the driving drain electrode 139.

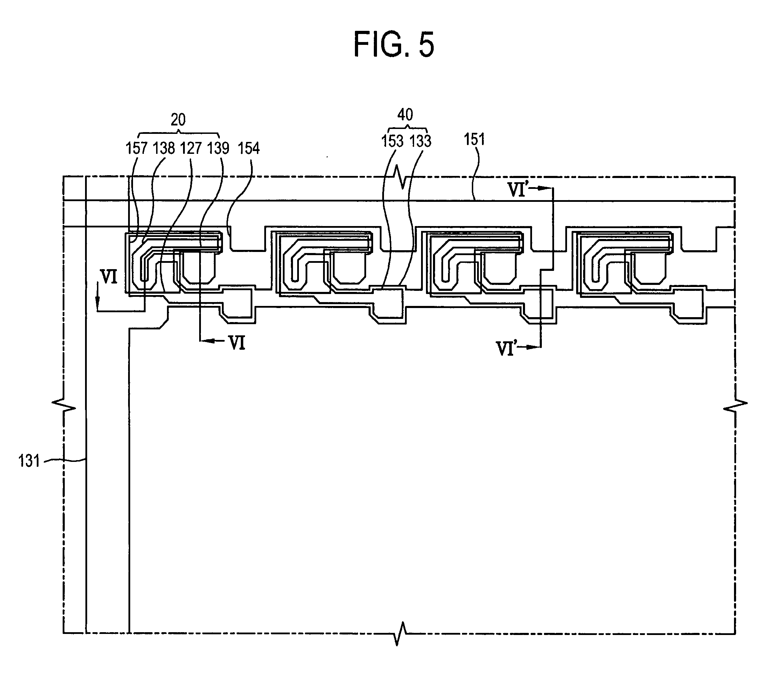

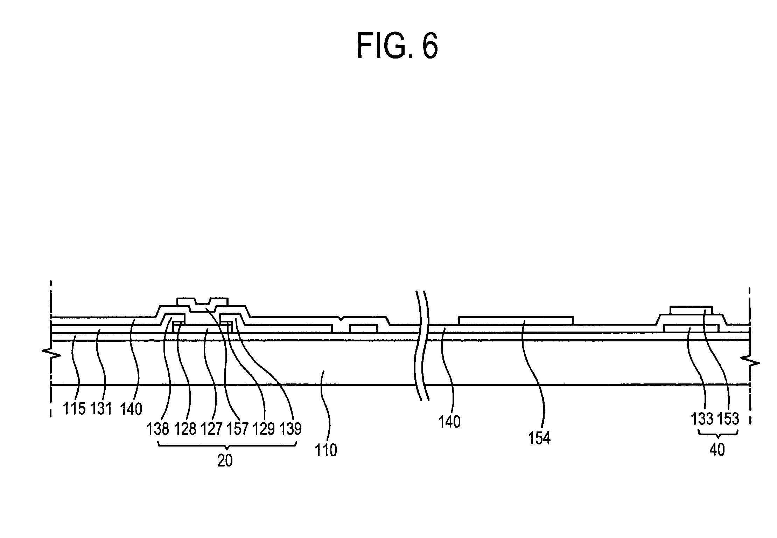

As shown in FIG. 5 and FIG. 6, silicon nitride or silicon oxide is deposited on the first conductive layers 131, 133, 138, and 139 by using plasma enhanced chemical vapor deposition (PECVD) so as to form the first insulating layer 140.

On the first insulating layer 140, a single-layer or multi-layer made of a metal containing at least one of molybdenum (Mo), chromium (Cr), titanium (Ti), tantalium(Ta), aluminum (Al), copper(Cu), and silver (Ag) is patterned so as to form the second conductive layer 151, 153, 154, and 157. The second conductive layers include the gate line 151, the driving gate electrode 157, the second storage electrode 153, and the switching gate electrode 154.

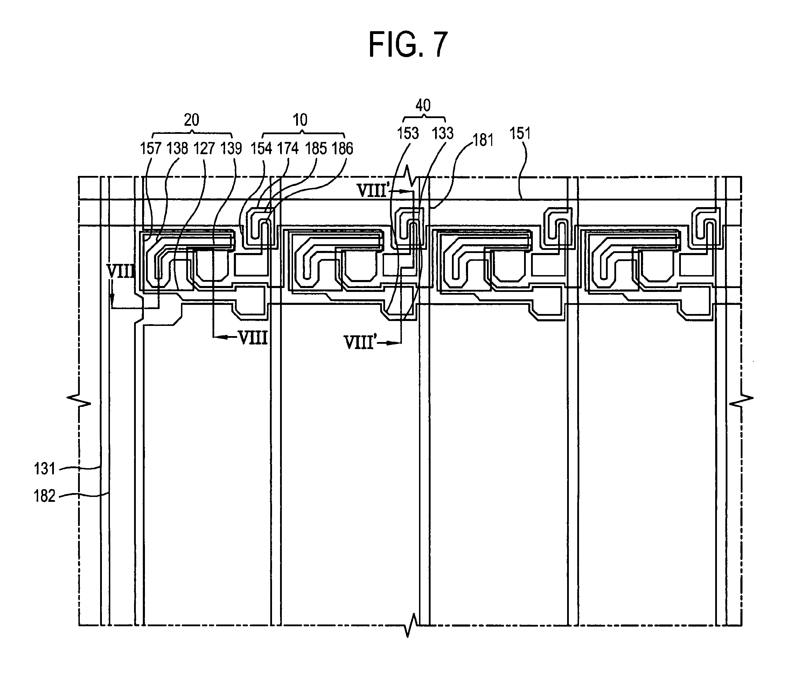

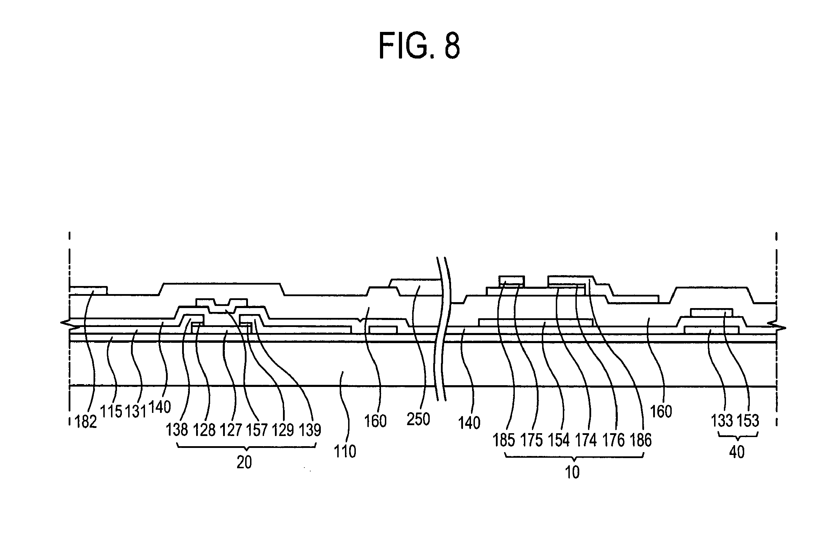

As shown in FIG. 7 and FIG. 8, the second insulating layer 160 is formed on the second conductive layers 151, 153, 154, and 157 in a substantially similar way as the first insulating layer 140. On the second insulating layer 160, the switching semiconductor layer 174 is formed. The switching semiconductor layer 174 overlaps the switching gate electrode 154. The switching semiconductor layer 174 is formed as an amorphous silicon layer. On the switching semiconductor layer 174, the switching ohmic contact layers 175 and 176 are formed. The switching ohmic contact layers 175 and 176 are formed as the amorphous silicon layer highly doped with an n-type impurity.

A single-layer or multi-layer made of a low resistivity metal such as aluminum (Al), copper (Cu), and silver(Ag) is patterned so as to form the third conductive layers 181, 182, 185, and 186. The third conductive layer includes the switching source electrode 185, the switching drain electrode 186, the data line 181, and the second common power line 182.

The color filter 250 is formed in a location that corresponds to the organic layer 320. The color filter 250 does not correspond to all the organic layers 320, and the color filter 250 is omitted in a pixel for emitting a white color light.

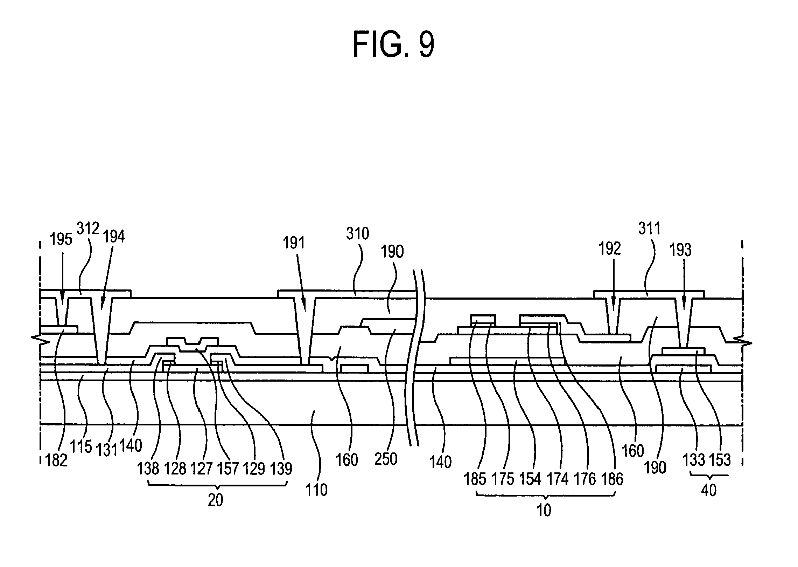

As shown in FIG. 9, on the third conductive layers 181, 182, 185, and 186 and the color filter 250, the passivation layer 190 made of a photoresist material is formed.

The first contact hole 191 and the fourth contact hole 194 that penetrate the passivation layer 190, the first insulating layer 140, and the second insulating layer 160 are formed. The third contact hole 193 penetrating the passivation layer 190 and the second insulating layer 160 is formed. The second contact hole 192 and the fifth contact hole 195 that penetrate the passivation layer 190 are formed.

On the passivation layer 190, the pixel electrode 310, the first connecting member 311, and the second connecting member 312 are formed. The pixel electrode 310, the first connecting member 311, and the second connecting member 312 are made of ITO or IZO, and they are transparent. The pixel electrode 310 is electrically connected to the driving drain electrode 139 through the first contact hole 191. The first connecting member 311 is electrically connected to the switching drain electrode 186 and the second storage electrode 153 through the second contact hole 192 and the third contact hole 193, respectively. The second connecting member 312 is electrically connected to the common power line 182 and the auxiliary common power line 131 through the fourth contact hole 194 and the fifth contact hole 195, respectively.

As shown in FIG. 1 and FIG. 2, the pixel definition layer 350 is formed on the pixel electrode 310, the first connecting member 311, and the second connecting member 322. The pixel definition layer 350 includes an opening that exposes the pixel electrode 310.

In the opening of the pixel definition layer 350, the organic layer 320 is formed on the pixel electrode 310 and then the common electrode 300 covering the pixel definition layer 350 and the organic layer 320 to complete the organic light emitting diode 30.

Through the above-described manufacturing method, occurrence of a defect such as short-circuit can be suppressed and electric characteristics of the display device 100 can be improved by reducing the overall resistivity.

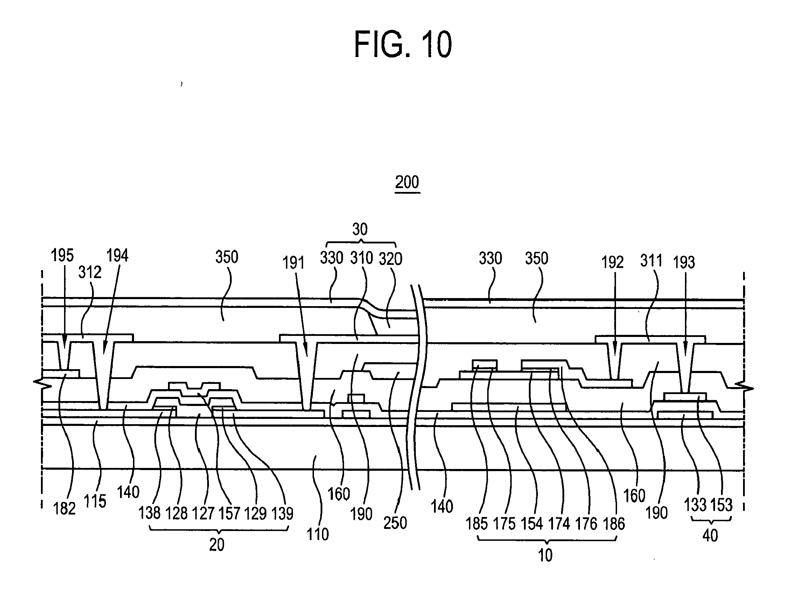

Referring to FIG. 10, an exemplary embodiment of the present invention will be described.

As shown in FIG. 10, in a driving TFT 20, a driving semiconductor layer 127 is formed on a driving source electrode 138 and a driving drain electrode 139. A portion of the driving semiconductor layer 127 overlaps the driving source electrode 138 and the driving drain electrode 139.

Driving ohmic contact layers 128 and 129 are respectively formed between the driving semiconductor layer 127 and the driving drain electrode 139 and between the driving semiconductor layer 127 and the driving drain electrode 139, and therefore the driving ohmic contact layers 128 and 129 are disposed below the driving semiconductor layer 127. With this configuration, the driving source electrode 138 and the driving drain electrode 139 are more distanced from a second conductive layer that includes a driving gate electrode 151.

A display device 200 can substantially prevent the driving source electrode 138 and the driving drain electrode 139 from contacting the gate electrode 157, thereby substantially preventing short-circuit.

As described above, according to exemplary embodiments of the present invention, the occurrence of the defect such as short-circuit can be suppressed and the electric characteristics of the display device can be improved by reducing the overall resistivity.

That is, the first conductive layer including the driving source electrode and the driving drain electrode of the thermally stabile driving TFT is made of a metal having relatively excellent thermal stability. Therefore, occurrence of hillock in the driving source electrode and the driving drain electrode can be suppressed. Accordingly, the driving source electrode and the driving drain electrode can be substantially prevented from contacting the driving gate electrode, thereby substantially preventing short-circuit thereof.

In addition, the first conductive layer has a relatively small thickness by using a metal having relatively excellent thermal stability compared to other conductive layers. the occurrence of hillock is substantially avoided in the first conductive layer since it is made of the metal having the excellent thermal stability. Since the first conductive layer can be formed as a single-layer, the thickness thereof is less than that of a multi-layer. A step difference due to the driving source electrode and the driving drain electrode can be reduced. Accordingly, the first insulating layer covering the driving source electrode and the driving drain electrode can be prevented from being thinned. Resultantly, the driving source electrode and the driving drain electrode can be substantially prevented from being short-circuited with other conductive layers such as the driving gate electrode.

The common power line electrically connected to the driving source electrode is included in the third conductive layer made of a metal having relatively low resistivity. A current flows through a common power line made of a low resistive metal so that a voltage drop due to resistance can be suppressed. The current mainly flows through the common power line and then transmitted to the driving source electrode, and electric characteristics of the display device can be improved. Accordingly, a constant voltage can be applied to an organic light emitting element of each pixel. The common power lines are formed in different two layers, and an operational error due to disconnection of one common power line can be substantially prevented since the other power common power line can be used.

Further, the overall resistivity of the display device is reduced, and therefore, the width of the common power line and the auxiliary common power wiring line can be reduced, and the display device can have an improved aperture ratio.

In addition, the above-described manufacturing method of the display device can be provided.

Although exemplary embodiments of the present invention have been shown and described, it will be appreciated by those skilled in the art that changes may be made in exemplary embodiments without departing from the principles and spirit of the invention.

## Claims

1. A display device comprising:
a first conductive layer including a driving source electrode and a driving drain electrode;
a second conductive layer insulated from the first conductive layer, and including a driving gate electrode, a switching gate electrode, and a gate line; and
a third conductive layer insulated from the first and second conductive layers, and including a switching source electrode, a switching drain electrode, a data line, and a common power line.

2. The display device of claim 1, wherein the first conductive layer is made of a first metal having high thermal stability compared to the third conductive layer, and the third conductive layer is made of a third metal having low resistivity compared to the first conductive layer.

3. The display device of claim 2, wherein the second conductive layer is made of a second metal containing at least one of molybdenum (Mo), chromium (Cr), titanium (Ti), tantalium (Ta), copper (Cu), aluminum (A1), and silver (Ag), wherein the first metal is one of molybdenum (Mo), chromium (Cr), titanium (Ti), and tantalium (Ta), and the third metal is one of copper (Cu), aluminum (Al), and silver (Ag).

4. The display device of claim 2, wherein the switching gate electrode is branched from the gate line, the switching source electrode is branched from the data line, the switching drain electrode is electrically connected to the driving gate electrode, and the driving source electrode is electrically connected to the common power line.

5. The display device of claim 4, further comprising:
a first storage electrode extended from the driving source electrode; and
a second storage electrode branched from the driving gate electrode and overlapping the first storage electrode,
wherein the first storage electrode and the second storage electrode form a capacitor.

6. The display device of claim 4, further comprising a first connection member and a second connection member formed on a layer that is different from the first, second, and third conductive layers,
wherein the first connection member electrically connects the switching drain electrode and the driving gate electrode, and the second connection member electrically connects the common power line and the driving source electrode.

7. The display device of claim 4, wherein the first conductive layer further comprises an auxiliary common power line extended from the driving source electrode, and the auxiliary common power line overlaps the common power line.

8. The display device of claim 4, further comprising an organic light emitting element electrically connected to the driving drain electrode.

9. The display device of claim 8, wherein the organic light emitting element comprises:
a pixel electrode formed on the third conductive layer and insulated therefrom and electrically connected to the driving drain electrode;
an organic layer formed on the first pixel electrode; and
a common electrode formed on the organic layer.

10. The display device of claim 9, wherein the pixel electrode is made of at least one of indium tin oxide (ITO) and indium zinc oxide (IZO).

11. The display device of claim 9, wherein the driving gate electrode, the driving source electrode, and the driving drain electrode form a driving thin film transistor, and the switching gate electrode, the switching source electrode, and the switching drain electrode from a switching thin film transistor.

12. The display device of claim 11, wherein the driving thin film transistor further comprises a driving semiconductor layer made of polysilicon, and the switching thin film transistor further comprises a switching semiconductor layer made of amorphous silicon.

13. The display device of claim 12, wherein the driving semiconductor layer is disposed below and overlapping the driving source electrode, the driving drain electrode, and the driving gate electrode, and the driving thin film transistor further comprises driving ohmic contact layers respectively interposed between the driving source electrode and the driving semiconductor layer and between the driving drain electrode and the driving semiconductor layer.

14. The display device of claim 12, wherein the driving semiconductor layers are interposed between the gate electrode and the driving source electrode and between the gate electrode and the driving drain electrode, and the driving thin film transistor further comprises driving ohmic contact layers interposed between the driving source electrode and the driving semiconductor and between the driving drain electrode and the driving semiconductor layer.

15. A display device manufacturing method comprising:
preparing a substrate member;
forming a first conductive layer including a driving source electrode and a driving drain electrode on the substrate member;
forming a second conductive layer including a driving gate electrode, a switching gate electrode, and a gate line on the substrate member having the first conductive layer formed thereof; and
forming a third conductive layer including a switching source electrode, a switching drain electrode, a data line, and a common power line on the substrate member having the first conductive layer and the second conductive layer formed thereof.

16. The display device manufacturing method of claim 15, wherein the first conductive layer is made of a first metal having high thermal stability compared to the third conductive layer, and the third conductive layer is made of a second metal having low resistivity compared to the first conductive layer.

17. The display device manufacturing method of claim 16, wherein the first, second, third conductive layers are respectively insulated from each other, the driving source electrode and the common electrode line are electrically connected to each other, and the switching drain electrode is electrically connected to the driving gate electrode.

18. The driving device manufacturing method of claim 16, further comprising:
forming a pixel electrode electrically connected to the driving drain electrode;
forming an organic layer on the pixel electrode; and
forming a common electrode on the organic layer.

19. The display device manufacturing method of claim 18, further comprising:
forming a driving thin film transistor including the driving gate electrode, the driving source electrode, and the driving drain electrode,
the driving thin film transistor further comprising a driving semiconductor layer made of polysilicon; and
forming a switching thin film transistor including the switching gate electrode, the switching source electrode, and the switching drain electrode, and
the switching thin film transistor further comprising a switching semiconductor made of amorphous silicon.
